# EUROPEAN PATENT SPECIFICATION

(11) **EP 0 396 093 B1**
(45) Date of publication and mention of the grant of the patent: **23.06.1999**
(21) Application number: 90108248.7
(22) Date of filing: 30.04.1990
(51) Int. Cl.: H01L 27/148

(54) **Charge transfer device having multiple registers**
Ladungsverschiebeanordnung mit mehreren Registern
Dispositif à transfert de charges ayant une pluralité de registres

(30) Priority: 02.05.1989 JP 11344889
(43) Date of publication of application: 07.11.1990
(73) Proprietor: SONY CORPORATION, Tokyo (JP)
(72) Inventor: Kawamoto, Seiichi, c/o Sony Corporation, Shinagawa-ku, Tokyo (JP); Narabu, Tadakuni, c/o Sony Corporation, Shinagawa-ku, Tokyo (JP)
(74) Representative: Müller, Frithjof E., Dipl.-Ing.

(56) References cited:
- EP-A- 0 127 223
- FR-A- 2 537 369
- US-A- 4 001 878
- PATENT ABSTRACTS OF JAPAN, vol. 12, no. 217 (E-624)[3064], 21st June 1988; & JP-A-63 14 467 (SONY CORP.) 21-01-1988
- IBM TECHNICAL DISCLOSURE BULLETIN, vol. 20, no. 1, June 1977, pages 436-437, New York, US; S.G. CHAMBERLAIN et al.: "Silicon solid-state FET color scanner"

## Description

### BACKGROUND OF THE INVENTION

### 1. Field of the Invention

The present invention relates to a charge transfer device in accordance with the precharacterising part of claim 1 and a charge coupled device imager using the same. A charge transfer device in accordance with the precharacterising part of claim 1 is known from US-A-4001878.

### 2. Description of the Prior Art

In a charge transfer device in general, such as a CCD, a region called a register for charge transfer is formed on its chip. A transfer electrode for potential control is formed in a side-by-side relation with respect to the register of the charge transfer device, and a channel region operating as the charge transfer route is formed below the transfer electrode.

The CCD solid state imager is a device consisting essentially of such charge transfer mechanism and an annexed sensor for opto-electric conversion. Above all, in a color solid state imager, there are formed filters of different color transmission types, and sensors associated with the different colors. For example, in a color linear sensor, there are formed one or more rows of sensors for outputting signals of different colors. In a device in which the sensors associated with the different colors are arrayed sequentially in a row, a register is provided in parallel with the sensor row. Signals of the different colors are collectively transferred to the register from the sensors so as to be allocated and read out in the order in which they are output. In a device in which plural rows of sensors are formed, a register is provided for each sensor row and outputs an associated one of the three color signals.

The number of the registers in the charge transfer device may not be one, and there may be cases wherein a plurality of registers are formed. When a plurality of registers are provided in parallel with one another, it becomes necessary to transfer electrical charges across the registers.

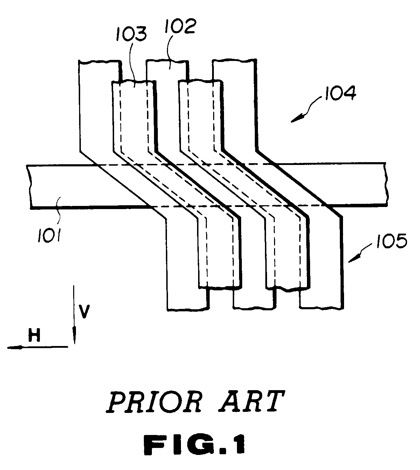

Fig. 1 shows to an enlarged scale the region between the adjacent registers of a conventional charge transfer device. A first polysilicon layer 101 is formed along the direction H. This first layer of polysilicon functions as a transfer gate between the registers. A second layer of polysilicon 102 and a third layer of polysilicon 103 are alternately formed at a predetermined pitch along the direction H shown in Fig. 1. The patterns of these polysilicon layers 102, 103 are extended in the direction V in Fig. 1 with obliquely extending portions over the polysilicon layer 101. The polysilicon layers 102, 103 function in common as the transfer electrodes for the first and second registers 104, 105 and are operated by two-phase driving. When the charges are transferred in the direction V, that is, across the registers 104, 105, a pulse is transmitted to the first polysilicon layer 101, and the electrical charges in the first register 104 are transiently stored in a lower portion of the first polysilicon layer 101. The charges thus stored in the first polysilicon layer 101 are then transferred to the second register 105.

However, with a color linear sensor, should the sensors associated with the different colors be arrayed sequentially in one sensor row, signal charges read into the registers may be degraded as they are being transferred in the registers, so that color mixing may occur in the produced image. Should a plurality of rows of registers be formed in association with a plurality of rows of sensor rows, the sensor rows may be unavoidably different in their positions to increase the load in signal processing.

On the other hand, should electrical charges be transferred across a plurality of registers, as shown in Fig. 1, the first layer of polysilicon 101 need be formed in a long pattern length along the direction H shown therein. However, a linear sensor or the like having a longer length along the direction H has an increased resistance. Also, when the charge transfer in the direction H is to be achieved by two phase driving, electrical charges need be transiently stored in a lower portion of the first layer of polysilicon 101 with consequent deterioration in the transfer efficiency.

US-A-4001878 as disclosing a charge transfer device in accordance with the precharacterizing part of claim 1 includes three parallel transfer registers for transferring charge signals from a CCD-image pick-up in a first (horizontal) direction and in a second (vertical) direction. For carrying out the transfer in vertical direction, the transfer electrodes of each transfer register are respectively arrayed contiguous to one another in horizontal transfer direction and in vertical transfer direction and are alternatively driven by and connected to one of a three-phase driving signal. These three driving signals are applied so that in a line of information only one third of the corresponding charges is taken over in the adjacent register at a time. At a next time, the second third of the charges of the line is taken over and the first third of the charges is transferred in vertical direction to the second adjacent register. At a third time, the third third of the charges of the line is taken in the first register, the second third of the charges is transferred in vertical direction to the second adjacent register and the first third of the charges of the line is transferred to the third register, and so on. For this operation, it is essential that the transfer electrodes are capable to transfer charges in vertical direction to the respective adjacent and contiguous transfer electrode of the adjacent register. Further, the transfer electrodes have ion implanted regions beneath their upper edges to prevent any upward transfer of charges during the charge transfer in the horizontal transfer direction.

### SUMMARY OF THE INVENTION

It is an object of the present invention to provide a charge transfer device having an improved charge transfer efficiency across plural registers, and is less subject to color mixing.

A charge transfer device according to the present invention is defined in claim 1.

Depending claims 2 to 6 are respectively specifying advantageous developments thereof.

Claim 7 specifies a charge coupled device imager comprising said charge transfer device in accordance with one of the preceding claims 1 to 3. Claims 8 and 9 are respectively specifying an advantageous development thereof.

In the charge transfer device of the present invention, since the registers are associated with the respective color sensors, each of the registers is associated with a specific one of the three primary color signals to prevent color mixing. Since the sensors are arrayed in a row, the outputs from the sensors are in the form of separate color signals.

In another aspect of the present invention, the different color transmitting filters are those including at least three filter units for a combination of red, green and blue or for a combination of cyan, yellow and magenta. The registers formed in parallel with the sensor row may be provided on one or both lateral sides of the sensor row.

In yet another aspect of the present invention, the transfer electrodes arrayed in contiguity to each other have an enlarged width on the electrode junction region. A transfer region may also be formed at the junction side of the charge receiving one of the transfer electrodes which are arrayed in contiguity to each other for realizing charge transfer across the associated registers.

### BRIEF DESCRIPTION OF THE DRAWINGS

Fig. 1 is a plan view showing essential portions of a typical conventional charge transfer device.

Fig. 2 is a plan view showing essential portions of an embodiment of a charge transfer device according to the present invention.

Fig. 3 is a waveform diagram for illustrating the charge transfer process in the charge transfer device shown in Fig. 2.

Fig. 4 is a plan view showing essential portions of a second embodiment of a charge transfer device according to the present invention.

Fig. 5 is a waveform diagram for illustrating the charge transfer process in the direction V in the embodiment shown in Fig. 4.

Fig. 6 is a waveform diagram for illustrating the charge transfer process in the direction H in the embodiment shown in Fig. 4.

Fig. 7 is a block diagram showing a third embodiment of the charge transfer device of the present invention.

Fig. 8 is a block diagram showing a fourth embodiment of the charge transfer device of the present invention.

Fig. 9 is a block diagram showing a fifth embodiment of the charge transfer device of the present invention.

Fig. 10 is a diagram showing the potential energy for illustrating the transfer process of the embodiment shown in Fig. 9.

### DETAILED DESCRIPTION OF THE PREFERRED EMBODIMENTS

### First Embodiment

The present embodiment shows an example of a CCD which is provided with first and second registers and in which electrical charges may be transferred not only in the interior of each of the registers but across adjacent one of the registers.

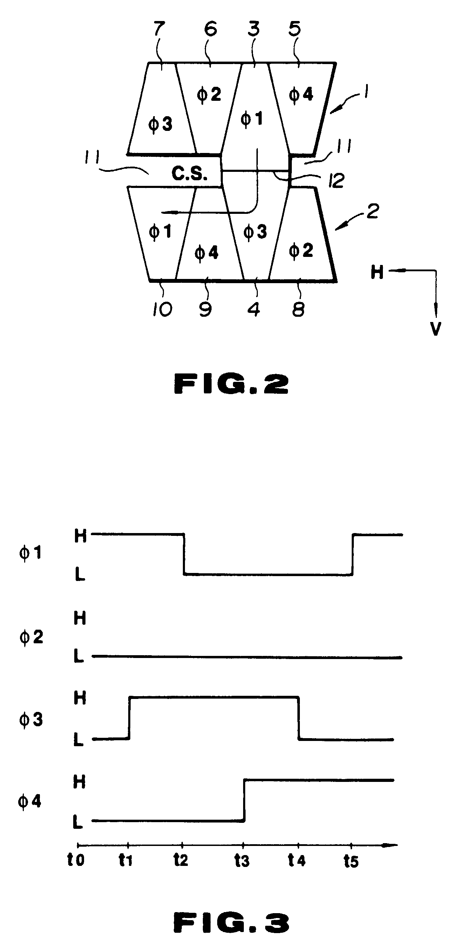

Fig. 2 shows in plan essential view the registers of the CCD in which a first register 1 and a second register 2 are formed in parallel with each other for transferring electrical charges in the direction H on a semiconductor substrate. On this Fig 2 , only two sets of the transfer electrodes in each of the registers are shown, for the sake of simplicity. The first register 1 has transfer electrodes 5, 3, 6 and 7, while the second register 2 has transfer electrodes 8, 4, 9 and 10. Although not shown, channels for charge transfer are formed in the lower regions of the transfer electrode 3 to 10. The transfer electrode 3 of first register 1 has its one side contiguous to one side of the transfer electrode 4 of second register 2. No transfer gate or the like is provided between the transfer electrodes 3 and 4. Although these transfer electrodes 3, 4 are contiguous to each other, the remaining transfer electrodes 5, 6 and 7 of the first register 1 are electrically isolated from the electrodes 8, 9 and 10 of the second register 2 by a channel stop region 11 formed between the first and the second registers 1, 2. The transfer electrode 3 has an increasing width towards the second register 2. Thus the electrode 3 has substantially a trapezoidal form and has an increased width in the transfer direction or in the direction V. similarly the transfer electrode 4 has substantially a trapezoidal form and has a progressively increasing width towards the junction with the transfer electrode 3. The remaining transfer electrodes 5 to 10 are also of substantially the trapezoidal form. The reason why the transfer electrodes 3 to 10 are substantially of the trapezoidal form is to provide a deeper potential and a shallower potential on the perimeter of the transfer electrode at the enlarged sides and the narrow sides, respectivley, for improving the transfer efficiency.

The transfer electrodes 3 to 10 are formed by, for example, three polysilicon layers. In the present embodiment, the transfer electrodes 4 and 7 are formed by a first polysilicon layer and the transfer electrodes 3 and 10 are formed by a second polysilicon layer. That is, at a junction region 12 where charge transfer between the registers occurs, the transfer electrode 3 is partially overlapped with the transfer electrode 4. The transfer electrodes 5, 6, 8 and 9 are formed by a third polysilicon layer.

A phase 1 signal φ 1 is supplied to transfer electrodes 3 and 10, and a phase 3 signal φ 3 is supplied to transfer electrodes 4 and 7. A phase 2 signal φ 2 or a phase 4 signal φ 4 are supplied to transfer electrode 5, 6, 8 and 9 formed by the third polysilicon layer. More specifically, the phase 4 signal φ 4 is supplied to transfer electrodes 5 and 9 and the phase 2 signal φ 2 is supplied to transfer electrodes 6 and 8.

With the above described CCD of the present embodiment, not only the transfer between the register, that is the transfer in the direction V, but also the transfer within the registers, that is the transfer in the direction H, may be realized.

Referring to Fig. 3, the case in which the charges present in the transfer electrode 3 are to be transferred to the transfer electrode 10. At time t₀, only the phase 1 signal φ 1 is set to an "H" level, with the remaining signals φ 2 to φ 4 being set to an "L" level. At this time, the electrical charges are stored in a lower portion of the transfer electrode 3. As the phase 3 signal φ 3 goes at the next clock time t₁ to the "H" level from the "L" level, the charges in the transfer electrode 3 start to flow into the transfer electrode 4. Since the transfer electrodes 8, 9 adjacent to the transfer electrode 4 within the register 2 are both at the "L" level, charge transfer is confined to the region of the transfer electrode 4. At the next clock time t₂, the first phase signal φ 1 goes to the "L" level. The potential at the charge receiving side transfer electrode 4 then becomes deeper than the potential of the charge transmitting side transfer electrode 3, so that the totality of the charges stored in the transfer electrode 3 flows to the transfer electrode 4 to effect charge transfer across the registers. Then, at time t₃, the phase 4 signal φ 4 goes from the "L" level to the "H" level, so that the charges which have been transferred to the transfer electrode 4 flow into the transfer electrode 9. Then, at time t₄, the signal φ 3 applied to the transfer electrode 4 goes to the "L" level, so that the charges are stored in the transfer electrode 9. At the next clock time t₅, these charges are transferred to the transfer electrode 10.

The charge transfer within the same register, the signal supplied to the transfer electrode to which the charges are to be transferred is raised from the "L" level to the "H" level. The signal supplied to the transfer electrode in which charges have been stored is lowered from the "H" level to the "L" level. The above sequence of operations is repeated sequentially from one to the next transfer electrode. With the above described control of the transfer electrodes, during charge transfer with the same register, the phase 1 signal φ 1 and the phase 3 signal φ 3, supplied respectively to the transfer electrodes 3, 4, responsible for charge transfer across the registers, are not changed in level simultaneously, nor are they set to the "H" level simultaneously, such that, when charges exist in one of the electrodes 3 or 4, the remaining electrode 4 or 3 is maintained at the "L" level without fail, thereby realizing positive charge transfer in the direction H within the same register.

Hence, with the CCD of the present embodiment, the transfer electrodes contiguous to each other are driven by different pulses to effect not only the transfer across the registers in the direction V but also the transfer within the same register in the direction H. Since the transfer between the registers takes place between the transfer electrodes 3, 4 which are contiguous to each other, transfer gates or the like may be eliminated. In addition, the problem of the gate resistance is obviated and the transfer efficiency is also improved. Above all, since the transfer electrodes 3, 4 are contoured so that the electrode widths are progressively increased towards the junction region 12, the transfer efficiency is further improved.

### Second Preferred Embodiment

The present embodiment gives an example of a linear type color CCD having first to third registers.

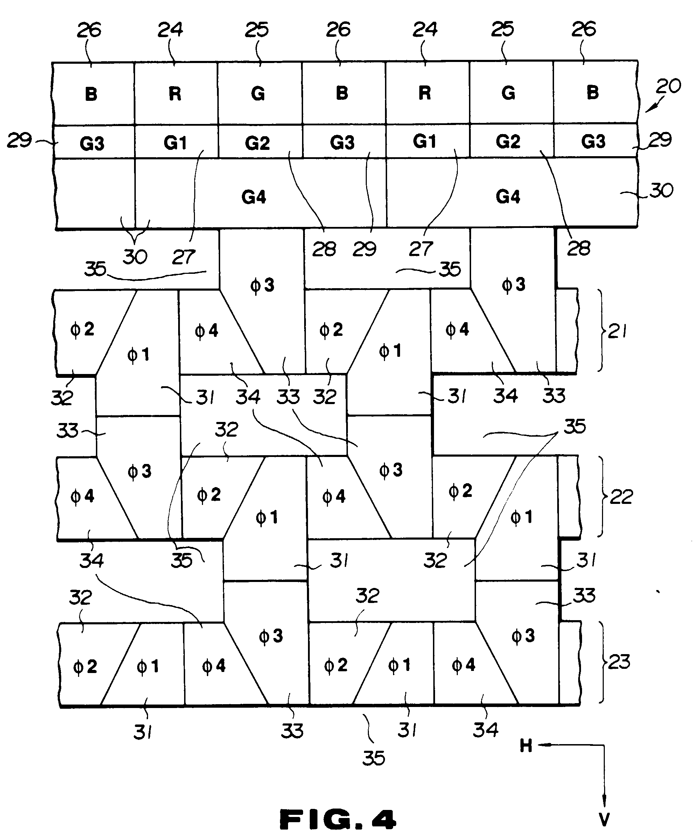

Fig. 4 shows the essential portions of the CCD. A sensor row 20 is formed with the direction H as the longitudinal direction. The sensor row 20 is constituted by a sequential linear array of first sensors 24 each having a filter for receiving a red (R) light, second filters 25 each having a filter for receiving a green (G) light and third filters 26 each having a filter for receiving a blue (B) light. The electrical charges corresponding to the red color signal, green color signal and the blue color signal are produced at the first, second and the third sensors 24, 25 and 26, respectively.

In the direction V of the sensor row 20, there are formed gate regions 27 to 30. These gate regions 27 to 30 function as the gates for selectively reading out signal charges from sensor row 20 for each of the sensors 24 to 26. Thus the gate region 27 supplied with the signal G1 is provided on the V direction side of the first sensor 24, and the gate region 28 supplied with the signal G2 is provided on the V direction side of the second sensor 25. Similarly, the gate region 29 supplied with the signal G3 provided on the V direction side of the third sensor 26. For each set of the adjacent gate regions 27 to 29, the gate region 30 controlled by the signal G4 is formed on the V direction side of the gate regions 27 to 29. This gate region 30 connects to a first register 21 which will be explained subsequently. The electrical charges are selectively read out from the sensor row 20 for each color signal when only one of the signals G1 to G3 is at the readout level, such as the "H" level and the signal G4 applied to the gate region 30 is simultaneously at the readout level.

With the present illustrative embodiment of the CCD, first to third register 21 to 23 are formed in parallel with the sensor row 20 having the gates each associated with one of the sensors 24 to 26. In each of the registers 21 to 23, transfer electrodes 31, 32, 33 and 34 are repetitively arrayed in this sequence in the direction H. A phase 1 signal φ 1 is supplied to the transfer electrodes 31 and a phase 2 signal φ 2 is supplied to the transfer electrodes 32. Similarly, a phase 3 signal φ 3 is supplied to the transfer electrodes 33 and a phase 4 signal φ 4 is supplied to the transfer electrode 34. The transfer electrodes 32 and 34 are electrically isolated from each other by a channel stop region 35 without any contact across the registers and are contiguous to the other transfer electrodes 31, 33 only within one and the same register. The transfer electrode 31, sandwitched between the transfer electrodes 32 and 34 within each of the registers 21 to 23, is contiguous on its one side in the direction V across the first and second registers 21 and 22 to the confronting side of the transfer electrode 33 of the other register. Beside the role as the horizontal transfer electrode in each register, the transfer electrode 31 plays the role of a transfer electrode for forwarding the charges across the first register 21 and the second register 22. The transfer electrode 33, similarly sandwitched between the transfer electrode 32 and 34 within each of the register 21 to 23, is contiguous on its one side to the confronting side of the transfer electrode 31 of the remaining register in the direction V. Besides the role as the horizontal transfer electrode in each register, the transfer electrode 33 plays the role of the charge receiving side transfer electrode in transferring the charges across the registers and transferring the charges from the sensor row 20. The transfer electrodes 32 and 34 are substantially of a trapezoidal form while the transfer electrode 31 is enlarged in width towards the transfer electrode 33 and the transfer electrode 33 is enlarged in width towards the transfer electrode 31. This allows the potential of the enlarged portion to be deeper than that of the narrow portion to rise the transfer efficiency of the transfer across the registers or within one and the same register.

The transfer electrodes 31 to 34 of the registers 21 to 23 may be formed by, for example, three polysilicon layers, similarly to the first embodiment. In the present second embodiment, the transfer electrode 33 is formed by a first polysilicon layer and the transfer electrode 31 is formed by a second polysilicon layer. The transfer electrodes 32 and 34 are formed by a third polysilicon layer.

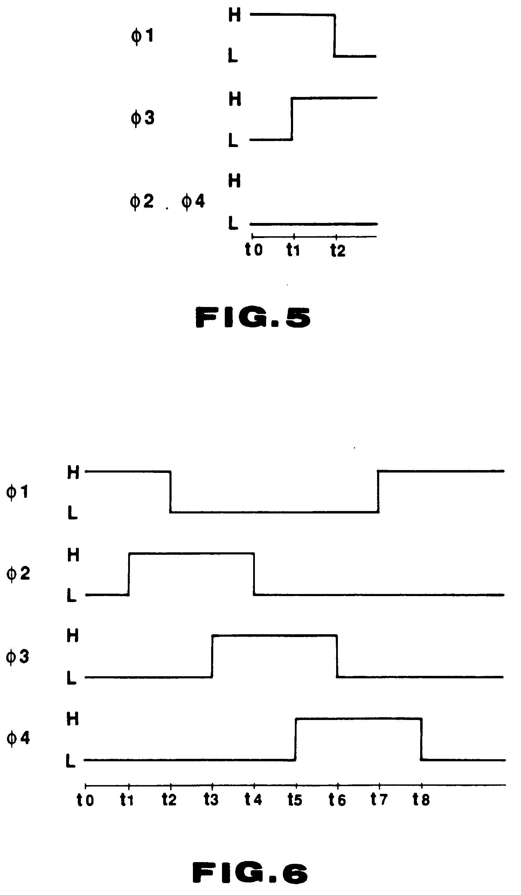

The charge transfer process in the direction V will be explained by referring to Fig. 5. It is supposed that, by the selective operation of the gate regions 27 to 30, the charges associated with the color signals are selectively transferred from the sensors 24 to 26 have been transferred and stored in the lower region of the transfer electrode 31. The signal φ 1 is at the "H" level and the remaining signals φ 2 to φ 4 are at the "L" level (at time t₀). When the charges are to be transferred across the registers, the signal φ 3 is changed to "H" level at time t₁, with the charges stored in the lower portion of the transfer electrode 31 flowing towards the lower portion of the transfer electrode 33. The signal φ 1 then is changed at time t₂ from the "H" level to the "L" level, with the potential of the charge receiving side transfer electrode 33 becoming deeper than the potential of the charge forwarding side transfer electrode 31. The totality of charges stored in the transfer electrode 31 are transferred to the transfer electrode 33, with the charges being stored only in the lower portion of the transfer electrode 33. During this time interval, the signals φ 2 and φ 4 are always at the "L" level, with no electrical charges flowing into the transfer electrodes 32, 34 to which these signals are supplied. The electrical charges are transferred in this manner in the direction V by these driving pulses. It is noted that transfer of charges from the sensor row 20 to the first register 21, from the first register 21 to the second register 22 and from the second register 22 to the third register 23 may be performed by fully parallel operation.

The charge transfer process in the direction H, that is the charge transfer in one and the same register, is explained by referring to Fig. 6. Such charge transfer in the direction H is performed by a repetitive alternative of a clock causing the charges to be stored in a region of two transfer electrodes and a clock causing the charges to be stored in a region of only one transfer electrode.

At time t₀, only the signal φ, 1 is at the "H" level, while the other signals φ 2 to φ 4 are at the "L" level. Therefore, even when the signal φ 1 is at the "H" level, since the signal φ 3 is at the "L" level, no charges flow out of the register of the transfer electrode 31 towards the region of the transfer electrode 33.

At time t₁, the signal φ 2 is changed from the "L" level to the "H" level. The charges thus far present only in the region of the transfer electrode 31 flow into the region of the transfer electrode 32. At time t₂ the signal φ 1 is changed to the "L" level, so that charges continue to be stored only in the lower portion of the transfer electrode 32.

Then, with the signal φ 1 at the "L" level, and with electrical charges becoming depleted in the region of the transfer electrode 31, the signal φ 3 is changed to the "H" level (time t₃). As a result, electrical charges in the region of the transfer electrode 32 flow into the region of the transfer electrode 33. Since the signal φ 1 is at the "L" level, charges cannot be transferred into the region of the transfer electrode 31 via the region of the transfer electrode 33. At time t₄ the signal φ 2 goes to "L" level, with the charges being stored only in the transfer electrode 33.

In time t₅ to t₈, signal φ 4 goes to the "H" level. The signal φ3 then goes to the "L" level, with the signal φ 1 again going to the "H" level. The charges in the region of the transfer electrode 33 thus are transferred to the region of the transfer electrode 31 via the region of the transfer electrode 31. During this time interval, it cannot occur that the signals φ 1 and φ 3 go to the "H" level simultaneously or are changed in level at the same timing, so that charges cannot be transferred across the adjacent registers in the direction V. By such charge transfer in the direction H in the registers 21 to 23, electrical charges associated with the respective color signals may be taken out at the registers 21 to 23.

With the above described embodiment of the CCD, charge transfer across the registers, that is in the direction V, may be effected between the adjacent electrodes, and the electrodes used for charge transfer in the direction V may simultaneously be used for charge transfer in one and the same register in the direction H. This results in elimination of the transfer gates or the like across the registers and in improved transfer efficiency. The color signals taken out from the sensor row 20 without positional deviation may be transferred, while the registers 21 to 23 may each be used for the three prime colors to prevent color mixing.

### Third Preferred Embodiment

The present third embodiment gives an example of a color line sensor having three separate registers for the three prime colors.

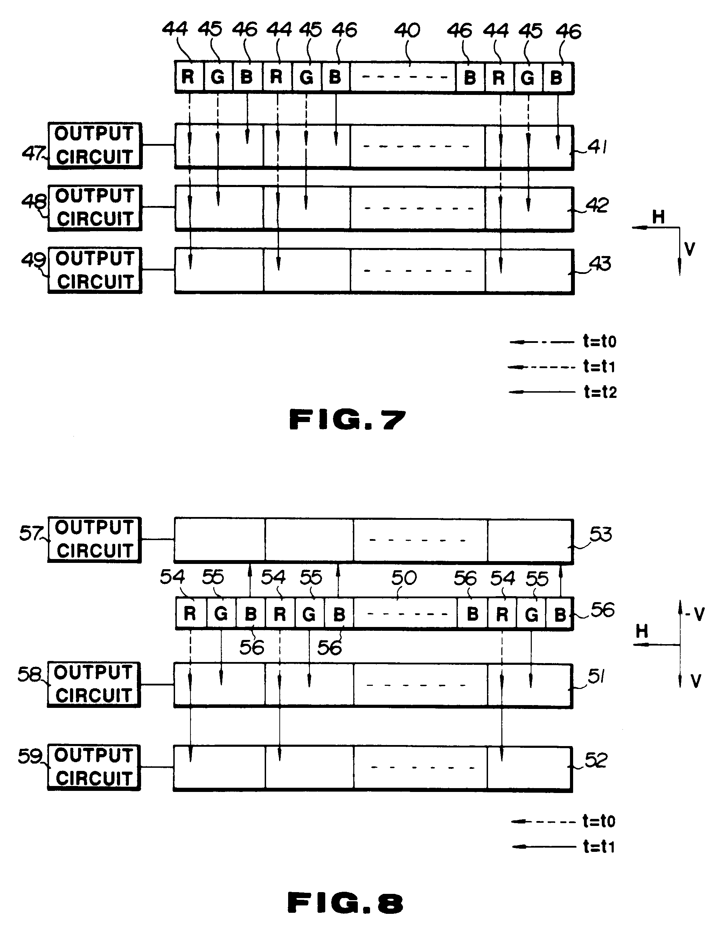

The line sensor of the present embodiment is constituted by a sensor row 40 having the direction H as the longitudinal direction, as shown in Fig. 7. The sensor row 40 is constituted by a sequential linear array of first sensors 44 each having a filter for receiving a red (R) light, second filters 45 each having a filter for receiving a green (G) light and third filters 46 each having a filter for receiving a blue (B) light. Three registers 41, 42 and 43 are provided in parallel with and on one lateral side of the sensor row 40 with the same direction H as the longitudinal direction. These first to third registers 41 to 43 are adapted for sequentially transferring the electrical charges in the direction H. Charge transfer can also be made across the first to third register 41 to 43 in the direction V. Output circuits 47, 48 and 49 are provided at the terminal ends of the registers 41 to 43 in the direction H. These output circuit 47, 48 and 49 issue output signals as a function of signal charges transferred through the registers 41 to 43.

With the above described line sensor, the sensors 44 to 46, which are the light receiving regions, are arrayed in a row without positional deviation for each color. By the following transfer across the registers, electrical charges are allocated to the first register 41, second register 42 and the third register 43 in the form of different color signals.

At time t₀, signal charges associated with the red color signals are read out from the first sensor 44 to the first register 41, as shown by a chain dotted line in Fig. 7. At this time, no charges are read from the second sensor 45 or from the third sensor 46.

Then, at time t₁, the previously read signal charges of the red signal are transferred from the first register 41 to the second register 42, as indicated by a broken line. Simultaneously, signal charges associated with the green color signal are read from the first sensor 45 to the first register 41, as shown by a broken line. Thus the charges of the red color signals and the green color signals are read to the second register 42 and to the first register 41, respectively.

Then, at time t₂, signal charges of the red color signals transferred to the second register 42 are transfereed to the third register 43, while signal charges of the green color signals are transferred from the first register 41 to the second register 42. At this time, signal charges of the blue signals are transferred from the sensor row 40 to the first register 41. By such charge transfer across the registers, signal charges of the blue signals are stored in the first register 41 and signal charges of the green signals are stored in the second register 42, while signal charges of the red signals are stored in the third register 43. Charge transfer is then performed across the registers 41 to 43 in the direction H to take out the outputs in the form of the different color signals from the output circuits 47 to 49.

In this manner, the outputs of the different color signals may be taken out with an advantage for signal processing. Since there are provided the registers associated with the respective colors, the widths of the transfer electrodes of the registers 41 to 43 may be increased, while the transfer frequency may be lowered, thereby improving the transfer efficiency.

### Fourth Preferred Embodiment

The present fourth embodiment is a modification of the third embodiment in which registers are provided on both sides of the sensor row.

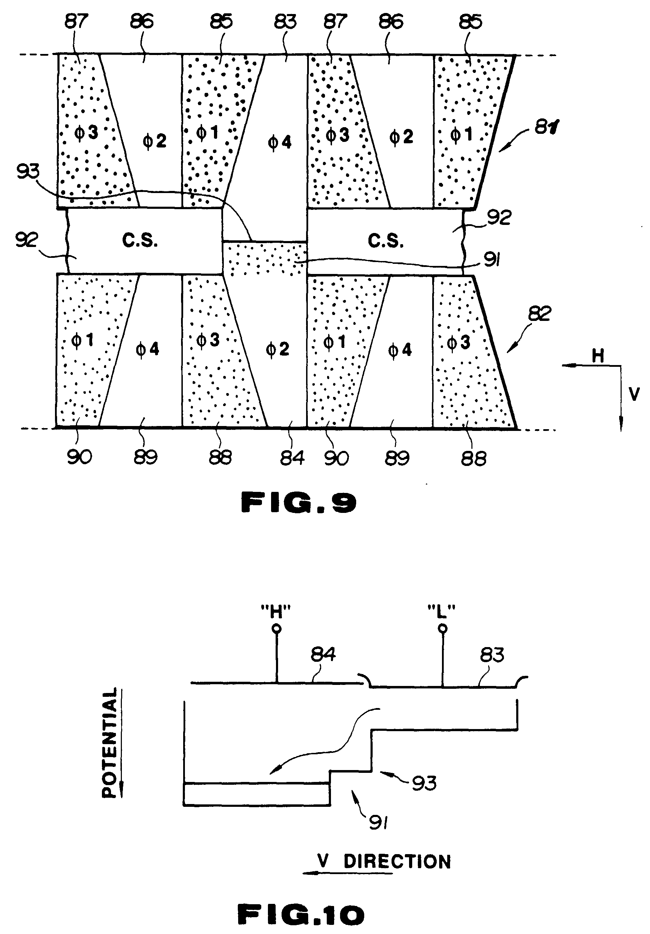

With the line sensor of the present embodiment, a sensor row 50 is formed, as shown in Fig. 8, with the direction H as the longitudinal direction. The sensor row 50 is constituted by a sequential linear array of first sensors 54 each having a filter for receiving a red (R) light, second filters 55 each having a filter for receiving a green (G) light and third filters 56 each having a filter for receiving a blue (B) light. Three registers 51, 52 and 53 are arrayed on the lateral sides o= the sensor row 50. The first register 51 and the second register 52 are arrayed in parallel with and on one lateral side of the sensor row 50, with the direction H as the longitudinal direction, and the third register 53 is arrayed on the other lateral side of and in parallel with the sensor row 50, with the direction H as the longitudinal direction. These registers 51 to 53 are adapted to transfer the charges sequentially in the direction H . Output circuits 57, 58 and 59 are provided at the terminal ends of the registers 51 to 53 in the direction H. These output circuits issue output signals associated with signal charges transferred by the registers 51 to 53. The electrical charges may be transferred across the first register 51 and the second register 52, while the signal charges may be read from the sensor row 50 to the first and third registers 51 and 53, in the form of different color signals.

In operation, electrical charges of the red color signals are read at time t₀ from the first sensor 54 to the first register 51, as shown by broken line in Fig. 8. No electrical charges are read from the sensors 55, 56 of the line sensor 50.

Then, at time t₁ electrical charges of the red signals previously read into the first register 51 are forwarded to the second register 52 by charge transfer across the registers as shown by solid line in Fig. 8. Simultaneously, electrical charges of the green color signals are transferred from the second sensor 55 of the sensor row 50 in the direction V to the first register 51, while electrical charges of the blue color signals are transferred from third sensor 56 of sensor row 50 to the third register 53 in the direction-V, as shown by a solid line in Fig. 8. As a result, electrical charges of the green color signals are stored in the first register 51, and electrical charges of the red color signals are stored in the second register 52, while electrical charges of the blue color signals are stored in the third register 53. The charge transfer is performed in each of the registers 51 to 53 in the direction H so that outputs of different color signals are taken out at the output circuits 57 to 59.

With the above described line sensor of the present fourth embodiment, signals of the different colors may be obtained from the registers 51 to 53 without the problem of color mixing. Only the signals of one and the same type are transferred in each of the registers 51 to 53, so that the number of or the interval between the transfer electrodes in the direction H of the registers 51 to 53 may be reduced, while the transfer frequency may be lowered and the transfer efficiency increased. As compared with the line sensor of the third embodiment, transfer across the registers occurs only once from the first register 51 to the second register 52 so that control signals to the register may be simplified.

### Fifth Preferred Embodiment

The present illustrative embodiment is a modification of the first embodiment, in which a first register 81 and a second register 82 for transferring electrical charges in the direction H are provided and the charge transfer may be made across the registers 81, 82 in the direction V.

In Fig. 9 showing the essential portions of the charge transfer device, the first register 81 and the second register 82 for transferring electrical charges in the direction H are arrayed parallel to each other with the direction H as the longitudinal direction. The first register 81 is provided with transfer electrodes 83, 85, 86 and 87, while the second register 82 is provided with transfer electrodes 84, 88, 89 and 90. The first register 81 and the second register 82 are electrically isolated from each other by a channel stop region 92, while the transfer electrodes 83 and 84 are protruded into the channel stop region 92 and are contiguous to each other at each one side with the channel being contiguous at the transfer electrodes 83 and 84 with the interposition of the junction region 93. The transfer electrodes 83, 84 are substantially trapezoidal in contour and are enlarged towards the junction region 93. The remaining transfer electrodes 85 to 90 are similarly trapezoidal in contour. With the transfer electrodes 83 to 90 of the substantially trapezoidal contour, it become possible to provide for a deep potential at the enlarged sides to improve the transfer efficiency.

One of the four-phase transfer signals φ 1 to φ 4 is supplied to each of the transfer electrodes 83 to 90. The phase 1 signal φ 1 is supplied to the transfer electrodes 85 and 90, while the phase 2 signal φ 2 is supplied to the transfer electrodes 84 and 86. The phase 3 signal φ 3 is supplied to the transfer electrodes 87 and 88, while the phase 4 signal φ 4 is supplied to the transfer electrodes 83 and 89. Of the transfer electrodes 83 to 90, the lower regions of the transfer electrodes 85, 87, 89 and 90 supplied with the signals φ 1 and φ 3 are formed as the transfer regions. The lower regions of the transfer electrodes 83, 84, 86 and 89 supplied with the signals φ 1 and φ 4 are formed as storage regions with a potential well deeper than in the transfer regions. In this manner, the storage and transfer regions are formed alternately in the registers 81 and 82 to improve the transfer efficiency. The lower region of the transfer electrode 84 is substantially formed as the storage section, and a transfer region 91 is formed in the adjacent region. In this manner, the electrical charges are advantageously not left in the adjacent region 93 when the lower channel region of the transfer electrode 84 is reset to the state of storing no electrical charges, while the transfer efficiency across the registers in the direction V may be improved.

Referring to Fig. 10, in which the charge transfer across the registers in the direction V is illustrated diagrammatically, the transfer region 91 is formed on the side of the transfer electrode 84 of the adjacent region 93. The potential well of the lower region of the transfer electrode 84 becomes shallower by a region equal to the region of the transfer region 91. In this manner, charge transfer from the lower region of the transfer electrode 83 towards the lower region of the transfer electrode 84 may be performed efficiently because the potential well becomes progressively deeper in the transfer direction.

On the other hand, charge transfer in the region of the signal φ 3 to the region of the signal φ 4 in the direction H may be made thanks to the potential difference even when both the signal φ 3 and the signal φ 4 are set to the "H" level, so that charge transfer may similarly be realized with a higher transfer efficiency.

## Claims

1. A charge transfer device for transferring signal charges comprising:
- a semiconductor substrate,
- a plurality of registers (1, 2; 21, 22, 23; 81, 82) formed on said semiconductor substrate for transferring electrical charges, said registers being formed in parallel to each other,
- each of said registers including
- a channel layer formed on said semiconductor substrate,
- an insulating film formed on said channel layer, and
- a plurality of sets of transfer electrodes, each of said sets comprising n transfer electrodes (3, 5, 6, 7, 4, 8, 9, 10; 31, 32, 33, 34; 83, 85, 86, 87, 84, 88, 89, 90) arrayed in juxtaposition and contiguous to one another along a first transfer direction (H) on said insulating film for effecting charge transfer in said first transfer direction (H) and respectively controllable by different n-phase driving signals (φ1, φ2, φ3, φ4), transfer electrodes having one side contiguous to transfer electrodes of an adjacent register to effect charge transfer in a second direction (V) between said one register (1; 21; 81) and said adjacent register (2; 22;82), wherein n is three or more,
characterized in that
- only a certain one of said n transfer electrodes within each set in one of the registers is arranged in contiguity to a respective one of the transfer electrodes of an adjacent set within an adjacent one of said registers and partially overlapped with said contiguous one of the transfer electrodes of the adjacent register and the remaining other transfer electrodes of each set within said registers are electrically isolated from the transfer electrodes of the adjacent set within the respective adjacent register by a channel stop region (11; 35; 92),
- the transfer electrode within each set having one side contiguous to a respective transfer electrode of an adjacent register has an increasing width towards the junction with the respective contiguous transfer electrode of each adjacent register, so that the potential of charge receiving side thereof becomes deeper than the potential of the charge forwarding side thereof,
and
said adjacent registers (1, 2; 21, 22; 81, 82) during transfer in the second direction (V) are controllable by at least one of the driving signals different from the driving signals driving the certain transfer electrodes which are partially overlapped with the corresponding contiguous transfer electrodes of the adjacent registers such that a shallow potential is effected in a channel region beneath a transfer electrode to which said at least one driving signal is supplied, and said certain transfer electrodes (3, 4; 31, 33; 83, 84) which are partially overlapped with the corresponding contiguous one of the adjacent registers are controllable by the driving signal supplied thereto such as not simultaneously causing deep potential in their respective channel regions during charge transfer in the first transfer direction (H) in one and the same register (1 or 2; 21 or 22; 81 or 82).

2. The charge transfer device according to claim 1, wherein n equals four, the transfer electrodes (3, 4; 31, 33; 83, 84) which are partially overlapped with the corresponding contiguous one of the adjacent registers enclose in the same register in the first transfer direction (H) three other transfer electrodes (32-34) inbetween, and wherein
- the transfer electrodes in the first transfer direction (H) on both sides of said transfer electrodes (3, 4; 31, 33; 83, 84) which are partially overlapped with the corresponding contiguous one of the adjacent registers are controllable by their driving signal as to render the potential in their channel portion between said transfer electrode shallower during transfer in said second transfer direction (V) between the registers.

3. The charge transfer device according to claim 1, wherein the junction region of the charge receiving side of one of said corresponding contiguous transfer electrodes partially overlapping one another between the adjacent registers has a transfer region therein in which the potential is shallowed.

4. The charge transfer device according to claim 1, wherein sensor means are provided for generating signal charges transferred to plural registers.

5. The charge transfer device according to claim 4, wherein said sensor means is a linear sensor.

6. The charge transfer device according to claim 4, wherein said sensor means is an area sensor.

7. A charge coupled device imager comprising
- a charge transfer device in accordance with one of the preceding claims 1 to 3,
- a sensor row constituted by a linear array of first sensors, second sensors and third sensors, said first, second and third sensor being formed on said semiconductor substrate and adapted for converting the light received by way of different color transmitting filters into signal charges,
- said registers are formed in parallel with said sensor row.

8. The CCD imager according to claim 7, wherein
- said registers are arrayed in juxtaposition to one another on one side of said sensor row.

9. The CCD imager according to claim 7, wherein said first register and said second register are arrayed on one side of said sensor row and said third register is arrayed on the other side of said sensor row.

## Patentansprüche

1. Ladungstransfervorrichtung zum Übertragen von Signalladungen, umfassend:
- ein Halbleitersubstrat,
- eine Vielzahl von Registern (1, 2; 21, 22, 23; 81, 82), die auf dem Halbleitersubstrat gebildet sind, um elektrische Ladungen zu übertragen, wobei die Register parallel zueinander gebildet sind,
- wobei jedes der Register aufweist:
- eine Kanalschicht, die auf dem Halbleitersubstrat gebildet ist,
- einen Isolierfilm, der auf der Kanalschicht gebildet ist, und
- eine Vielzahl von Sätzen von Transferelektroden, wobei jeder der Sätze n Transferelektroden (3, 5, 6, 7, 4, 8, 9, 10; 31, 32, 33, 34; 83, 85, 86, 87, 84, 88, 89, 90) aufweist, die nebeneinander und aneinandergrenzend längs einer ersten Transferrichtung (H) auf dem Isolierfilm angeordnet sind, um einen Ladungstransfer in der ersten Transferrichtung (H) zu bewirken, und die jeweils durch verschiedene n-Phasen-Ansteuersignale (φ1, φ2, φ3, φ4) steuerbar sind, die Transferelektroden eine an Transferelektroden eines benachbarten Registers angrenzende Seite haben, um einen Ladungstransfer in einer zweiten Richtung (V) zwischen dem einen Register (1; 21; 81) und dem benachbarten Register (2; 22; 82) zu bewirken, wobei n drei oder mehr ist,
dadurch gekennzeichnet, daß
- lediglich eine gewisse Elektrode der n Transferelektroden innerhalb jedes Satzes in einem der Register angrenzend an eine jeweilige eine Elektrode der Transferelektroden eines benachbarten Satzes innerhalb eines benachbarten Registers der Register angeordnet und teilweise überlappt mit der angrenzenden einen Elektrode der Transferelektroden des benachbarten Registers ist und die verbleibenden anderen Transferelektroden von jedem Satz innerhalb der Register elektrisch von den Transferelektroden des benachbarten Satzes innerhalb des jeweiligen benachbarten Registers durch einen Kanalstopbereich (11; 35; 92) isoliert sind,
- die Transferelektrode innerhalb jedes Satzes mit einer Seite, die an eine jeweilige Transferelektrode eines benachbarten Registers angrenzt, eine zu dem Übergang mit der jeweiligen angrenzenden Transferelektrode jedes benachbarten Registers zunehmende Breite hat, so daß das Potential der Ladungsempfangsseite hiervon tiefer wird als das Potential der Ladungslieferseite hiervon, und
- die benachbarten Register (1, 2; 21, 22; 81, 82) während eines Transfers in der zweiten Richtung (V) durch wenigstens eines der Ansteuersignale, die von den Ansteuersignalen verschieden sind, welche die gewissen Transferelektroden ansteuern, steuerbar sind, wobei die gewissen Transferelektroden teilweise mit den entsprechenden angrenzenden Transferelektroden der benachbarten Register überlappt sind derart, daß ein flaches Potential in einem Kanalbereich unter einer Transferelektrode bewirkt ist, zu welcher das wenigstens eine Ansteuersignal gespeist ist, und die gewissen Transferelektroden (3, 4; 31, 33; 83, 84), die teilweise mit der entsprechenden angrenzenden einen Elektrode der benachbarten Register überlappt sind, durch das Ansteuersignal steuerbar sind, das dort derart eingespeist ist, daß nicht gleichzeitig ein tiefes Potential in deren jeweiligen Kanalbereichen während eines Ladungstransfers in der ersten Transferrichtung (H) in einem und demselben Register (1 oder 2; 21 oder 22; 81 oder 82) bewirkt wird.

2. Ladungstransfervorrichtung nach Anspruch 1, bei der n gleich zu vier ist, die Transferelektroden (3, 4; 31, 33; 83, 84), die teilweise mit der entsprechenden einen Elektrode der benachbarten Register überlappt sind, in dem gleichen Register in der ersten Transferrichtung (H) drei andere Transferelektroden (32-34) dazwischen einschließen, und wobei
- die Transferelektroden in der ersten Transferrichtung (H) auf beiden Seiten der Transferelektroden (3, 4; 31, 33; 83, 84), die teilweise mit der entsprechenden einen angrenzenden Elektrode der benachbarten Register überlappt sind, durch deren Ansteuersignal steuerbar sind, um das Potential in deren Kanalteil zwischen der Transferelektrode flacher während eines Transfers in der zweiten Transferrichtung (V) zwischen den Registern zu machen.

3. Ladungstransfervorrichtung nach Anspruch 1, bei der der Übergangsbereich der Ladungsempfangsseite von einer Elektrode der entsprechenden angrenzenden Transferelektroden, die teilweise einander zwischen den benachbarten Registern überlappen, einen Transferbereich darin hat, in welchem das Potential flach gemacht ist.

4. Ladungstransfervorrichtung nach Anspruch 1, bei der Sensoreinrichtungen zum Erzeugen von Signalladungen, die zu mehreren Registern übertragen sind, vorgesehen sind.

5. Ladungstransfervorrichtung nach Anspruch 4, bei der die Sensoreinrichtung ein Linearsensor ist.

6. Ladungstransfervorrichtung nach Anspruch 4, bei der die Sensoreinrichtung ein Flächensensor ist.

7. Abbildungseinrichtung mit ladungsgekoppelter Vorrichtung, umfassend:
- eine Ladungstransfervorrichtung nach einem der vorangehenden Ansprüche 1 bis 3,
- eine Sensorreihe, die durch eine Linearanordnung von ersten Sensoren, zweiten Sensoren und dritten Sensoren gebildet ist, wobei die ersten, zweiten und dritten Sensoren auf dem Halbleitersubstrat gebildet und gestaltet sind, um das Licht, das über verschiedene Farbübertragungsfilter empfangen ist, in Signalladungen umzusetzen,
- wobei die Register parallel mit der Sensorreihe gebildet sind.

8. CCD-Abbildungsvorrichtung nach Anspruch 7, bei der:
- die Register nebeneinander auf einer Seite der Sensorreihe angeordnet sind.

9. CCD-Abbildungsvorrichtung nach Anspruch 7, bei der das erste Register und das zweite Register auf einer Seite der Sensorreihe angeordnet sind und das dritte Register auf der anderen Seite der Sensorreihe angeordnet ist.

## Revendications

1. Dispositif de transfert de charge pour transférer des charges de signal, comprenant :
un substrat semiconducteur ;
une pluralité de registres (1, 2 ; 21, 22, 23 ; 81, 82) formés sur ledit substrat semiconducteur pour transférer des charges électriques, lesdits registres étant formés en parallèle les uns aux autres,
chacun desdits registres incluant :
une couche de canal formée sur ledit substrat semiconducteur ;
un film isolant formé sur ladite couche de canal ; et
une pluralité de jeux d'électrodes de transfert, chacun desdits jeux comprenant n électrodes de transfert (3, 5, 6, 7, 4, 8, 9, 10 ; 31, 32, 33, 34 ; 83, 85, 86, 87, 84, 88, 89, 90) agencées en juxtaposition et de manière à être contiguës les unes aux autres suivant une première direction de transfert (H) sur ledit film isolant pour réaliser un transfert de charge suivant ladite première direction de transfert (H) et pouvant être commandées respectivement par différents signaux de pilotage de n phases (ϕ1, ϕ2, ϕ3, ϕ4), des électrodes de transfert comportant un côté contigu à des électrodes de transfert d'un registre adjacent afin de réaliser un transfert de charge suivant une seconde direction (V) entre ledit un registre (1 ; 21 ; 81) et ledit registre adjacent (2 ; 22 ; 82) où n vaut trois ou plus, caractérisé en ce que seulement l'une certaine desdites n électrodes de transfert dans chaque jeu dans l'un des registres est agencée de manière à être contiguë à l'une respective des électrodes de transfert d'un jeu adjacent dans l'un adjacent desdits registres et de manière à être chevauchée partiellement par ladite une contiguë des électrodes de transfert du registre adjacent, et les autres électrodes de transfert restantes de chaque jeu dans lesdits registres sont isolées électriquement des électrodes de transfert du jeu adjacent dans le registre adjacent respectif par une région d'arrêt de canal (11 ; 35 ; 92), l'électrode de transfert dans chaque jeu comportant un côté contigu à une électrode de transfert respective d'un registre adjacent présente une largeur croissant en direction de la jonction avec l'électrode de transfert contiguë respective de chaque registre adjacent de telle sorte que le potentiel de son côté de réception de charge devienne plus profond que le potentiel de son côté d'avancement de charge ; et
lesdits registres adjacents (1, 2 ; 21, 22 ; 81, 82) pendant un transfert suivant la seconde direction (V) peuvent être commandés par au moins l'un des signaux de pilotage différents des signaux de pilotage pilotant les certaines électrodes de transfert qui sont partiellement chevauchées par les électrodes de transfert contiguës correspondantes des registres adjacents de telle sorte qu'un potentiel peu profond soit réalisé dans une région de canal au-dessous d'une électrode de transfert sur laquelle ledit au moins un signal de pilotage est appliqué, et lesdites certaines électrodes de transfert (3, 4 ; 31, 33 ; 83, 84) qui sont chevauchées partiellement par celui contigu correspondant des registres adjacents peuvent être commandées par le signal de pilotage appliqué dessus de manière à ne pas générer simultanément un potentiel profond dans leurs régions de canal respectives pendant un transfert de charge suivant la première direction de transfert (H) dans le seul et même registre (1 ou 2 ; 21 ou 22 ; 81 ou 82).

2. Dispositif de transfert de charge selon la revendication 1, dans lequel n est égal à quatre, les électrodes de transfert (3, 4 ; 31, 33 ; 83, 84) qui sont chevauchées partiellement par celui contigu correspondant des registres adjacents renferment dans le même registre suivant la première direction de transfert (H) trois autres électrodes de transfert (32 - 34) entre, et dans lequel :
les électrodes de transfert suivant la première direction de transfert (H) sur les deux côtés desdites électrodes de transfert (3, 4 ; 31, 33 ; 83, 84) qui sont partiellement chevauchées par celui contigu correspondant des registres adjacents peuvent être commandées par leur signal de pilotage de manière à rendre le potentiel dans leur partie de canal entre ladite électrode de transfert moins profond pendant le transfert suivant ladite seconde direction de transfert (V) entre les registres.

3. Dispositif de transfert de charge selon la revendication 1, dans lequel la région de jonction du côté de réception de charge de l'une desdites électrodes de transfert contiguës correspondantes se chevauchant partiellement les unes les autres entre les registres adjacents comporte une région de transfert dedans dans laquelle le potentiel est rendu peu profond.

4. Dispositif de transfert de charge selon la revendication 1, dans lequel un moyen de capteur est prévu pour générer des charges de signal transférées jusqu'à plusieurs registres.

5. Dispositif de transfert de charge selon la revendication 4, dans lequel ledit moyen de capteur est un capteur linéaire.

6. Dispositif de transfert de charge selon la revendication 4, dans lequel ledit moyen de capteur est un capteur bidimensionnel.

7. Imageur à dispositif à couplage de charge comprenant
un dispositif de transfert de charge selon l'une quelconque des revendications précédentes 1 à 3 ;
une rangée de capteurs constituée par un réseau linéaire de premiers capteurs, de seconds capteurs et de troisièmes capteurs, lesdits premiers, seconds et troisièmes capteurs étant formés sur ledit substrat semiconducteur et étant adaptés pour convertir la lumière reçue au moyen de différents filtres de transmission de couleur selon des charges de signal ; et
lesdits registres sont formés en parallèle avec ladite rangée de capteurs.

8. Imageur CCD selon la revendication 7, dans lequel :
lesdits registres sont agencés en juxtaposition les uns par rapport aux autres sur un côté de ladite rangée de capteurs.

9. Imageur CCD selon la revendication 7, dans lequel ledit premier registre et ledit second registre sont agencés sur un côté de ladite rangée de capteurs et ledit troisième registre est agencé sur l'autre côté de ladite rangée de capteurs.
